# EUROPEAN PATENT APPLICATION

(11) **EP 4 745 565 A1**
(43) Date of publication of application: **20.05.2026**
(21) Application number: 25215678.1
(22) Date of filing: 13.11.2025
(51) Int. Cl.: G01N 23/225, H01J 37/26

(54) **METHODS OF COLLECTING A MULTIDIMENSIONAL DATA SET AND ASSOCIATED SYSTEMS**

(30) Priority: 15.11.2024 US 202418949910
(71) Applicant: FEI Company, Hillsboro, OR 97124-5793 (US)
(72) Inventor: FREITAG, Bert, Weilerswist (DE); KIEFT, Erik, Eindhoven (NL); SHANEL, Ondrej, 62700 Brno (CZ)
(74) Representative: Boult Wade Tennant LLP

(57) **Abstract**

In an example, a method includes recording a plurality of data frames by performing test location measurements at a plurality of sample test locations and recording response signals. Each test location measurement is characterized by a phase delay. For at least one sample test location, the test location measurement is performed with a repeated phase delay in nonconsecutive measurements. In another example, the test location measurement is performed at each sample test location such that different respective phase delays are used at each of two or more different sample test locations. In another example, a CPM system is configured to direct an illumination pulse of a charged particle beam to a sample test location, to apply an excitation stimulus to the sample test location, and to receive one or more response signals. The CPM system includes a controller programmed to execute one or more methods disclosed herein.

## Description

### FIELD

The present disclosure relates generally to methods of collecting a multidimensional data set, and associated systems. More specifically, the present disclosure relates to methods and systems for collecting a data set generated by a charged particle microscope system across various spatial and temporal dimensions.

### BACKGROUND

A transmission electron microscope system may be used to study a sample response to an excitation stimulus via sequential excitation and probing of a sample area. For example, when the sample response corresponds to a reversible process, the process may be studied via repeated sequential excitation-probe cycles at a sample test location. Varying a phase delay between the excitation and the probe illumination can yield a time-resolved measurement of the sample response at the probed location. Repeating such measurements across an area of the sample can further expand the collected data set across the spatial dimensions of the probed area.

When performing ultrafast electron microscopy using repeated stroboscopic measurements, the signal collected for each excitation-probe cycle may be very small. These small signals may necessitate long exposure times and/or repeated measurements at a given sample test location to accumulate a useful measurement. As a result, the total time needed to collect a sufficient signal across a full probed area of the sample may be undesirably long. In some examples, such a long measurement duration can allow for undesirable spatial drift of the probed area before the measurement is complete. In other examples, such a long measurement duration can delay providing a user with an indication that the data were collected under conditions that render the data unusable, resulting in wasted time.

### SUMMARY

**In** a representative example, a method of collecting a data set includes recording a plurality of data frames by, for each data frame of the plurality of data frames, performing a test location measurement at each sample test location of a plurality of sample test locations. The performing the test location measurement includes, for each sample test location, applying an excitation stimulus to the sample test location at a stimulus time, directing a charged particle beam to the sample test location at a probe time that is separated from the stimulus time by a phase delay, and recording one or more response signals that are generated via an interaction between the charged particle beam and the sample. For at least one repeated sample test location, the method includes repeating the performing the test location measurement with a repeated phase delay in non-consecutive test location measurements.

**In** another representative example, a method of collecting a data set includes recording a data frame by performing a test location measurement at each sample test location of a plurality of sample test locations. The performing the test location measurement includes, for each sample test location, applying an excitation stimulus to the sample test location at a stimulus time, directing a charged particle beam to the sample test location at a probe time that is separated from the stimulus time by a phase delay, and recording one or more response signals that are generated via an interaction between the charged particle beam and the sample. The recording the data frame includes performing the test location measurement at each sample test location such that a single phase delay is used at each sample test location and performing the test location measurement with different respective phase delays at each of two or more different sample test locations of the plurality of sample test locations.

**In** another representative example, a charged particle microscope (CPM) system includes a charged particle emitter configured to generate a charged particle beam, an optical assembly configured to direct and focus an illumination pulse of the charged particle beam to a sample test location on a sample positioned in a sample plane, an excitation source configured to apply an excitation stimulus to the sample test location, a detector subassembly configured to receive one or more response signals that are generated via an interaction between the illumination pulse and the sample, and a controller. The controller includes a processor system and a memory comprising instructions that, when executed by the processor system, cause the CPM system to record a plurality of data frames by, for each data frame of the plurality of data frames, performing a test location measurement at each sample test location of a plurality of sample test locations of the sample. The performing the test location measurement includes applying the excitation stimulus to the sample test location with the excitation source at a stimulus time, directing the illumination pulse to the sample test location at a probe time that is separated from the stimulus time by a phase delay, and recording one or more response signals that are generated via an interaction between the charged particle beam and the sample. The method includes, for at least one repeated sample test location, repeating the performing the test location measurement with a repeated phase delay in non-consecutive test location measurements.

The foregoing and other objects, features, and advantages of the invention will become more apparent from the following detailed description, which proceeds with reference to the accompanying figures.

### BRIEF DESCRIPTION OF THE DRAWINGS

FIG. 1 is a schematic representation of a CPM system according to an example.
FIG. 2 is a representation of a sequence of measurements that may be performed to record a plurality of data frames according to an example.
FIG. 3 is a representation of a sequence of measurements that may be performed to record a plurality of data frames according to another example.
FIG. 4 is a representation of a sequence of measurements that may be performed to record a plurality of data frames according to another example.
FIG. 5 is a flow chart depicting a method of collecting a data set according to an example.
FIG. 6 is a schematic representation of a computing system that may be used to perform one or more methods of the present disclosure according to an example.

### DETAILED DESCRIPTION

The present disclosure is directed to methods of collecting a data set, such as with a charged particle microscope (CPM) system such as a scanning electron microscope (SEM) system and/or a scanning transmission electron microscope (STEM) system. In particular, the methods disclosed herein can yield useful and/or actionable information more quickly than is offered by traditional methods. Such methods may be particularly beneficial, for example, when performing stroboscopic measurements in ultrafast electron microscopy analyses, which may require the repeated collection of low-intensity signals across various spatial and/or temporal dimensions.

A transmission electron microscope (TEM) system may be used to study a sample response to an excitation stimulus via sequential excitation and probing of a sample area. For example, a test location of the sample can be energized with the excitation stimulus that is highly localized in time. Subsequent probing of the test location with an incident electron beam can yield a variety of response signals that can be collected to characterize the sample response to the excitation stimulus. When the sample response corresponds to a reversible process, the measurements may be repeated with varying phase delays separating the incidences of the excitation stimulus and the electron beam probe upon the sample to study the evolution of the sample response over a period of time.

Such time-resolved studies may be performed in an ultrafast regime in which the duration of each excitation stimulus, the duration of the illumination of the sample by the probing electron beam, and the phase delay separating such events must be very carefully controlled. For example, the excitation stimulus and/or the illumination may be performed at a picosecond or femtosecond time scale and may be separated by a phase delay on the order of nanoseconds to femtoseconds or shorter. As a result, the signal to be collected by the TEM system for each measurement may be very small, necessitating repeated measurements for a given phase delay to accumulate sufficient data to yield a statistically meaningful measurement. Such repetition, however, can result in a lengthy total experiment time. For example, total exposure times of seconds or minutes may be required to collect sufficient data corresponding to a range of phase delays at a given test location.

This experimental duration can be further compounded when the experiment is extended to probe a plurality (e.g., a grid) of test locations on the sample with the TEM operating as a STEM. For example, probing a grid of 512 x 512 sample test locations with a 100 ms stroboscopic experiment at each sample test location yields a total experiment time of greater than 7 hours. When each test location is probed in sequence in this manner, a representation (e.g., image) of the sample area being tested may be available only after completion of the experiment, during which time the experiment may suffer from a variety of adverse conditions. For example, effects such as drift of the sample relative to the charged particle beam, damage to the sample by the charged particle beam, and/or sub-optimal measurement parameters may be evident only upon completion of the experiment, leading to wasted time if the data collected are eventually revealed to be unusable.

The present disclosure is directed to methods for data collection that avoid such shortcomings. For example, such methods can provide a user with an indication of the status or health of an experiment while the experiment is in process, and/or can enable adjustment of various experimental parameters prior to completion of the full experiment.

The present disclosure generally is directed to examples in which the data collection methods are performed in conjunction with the operation of a CPM system. In particular, the present disclosure describes various examples in which the CPM system is an electron microscope system, such as a scanning electron microscope (SEM) system and/or a STEM system, in which the charged particle beam is an electron beam. This is not required of all examples, however, and it additionally is within the scope of the present disclosure that the methods of the present disclosure may be applied to any other system, such as other charged particle microscope systems and/or optical systems.

As used herein, the term "experiment," as used to describe operation of a microscopy system with respect to a sample, is intended to refer to any applicable set or sequence of measurements that are recorded with variation of one or more experimental parameters through respective parameter ranges. The present disclosure generally is directed to examples in which an experiment includes stroboscopic excitations and measurements of each of a plurality of sample test locations and at each of a range of phase delays. It is to be understood, however, that an experiment also may refer to process that varies more or fewer than these parameters. As examples, additional parameters that may be varied in the course of an experiment include a focal plane of the charged particle beam, a beam current of the charged particle beam, etc.

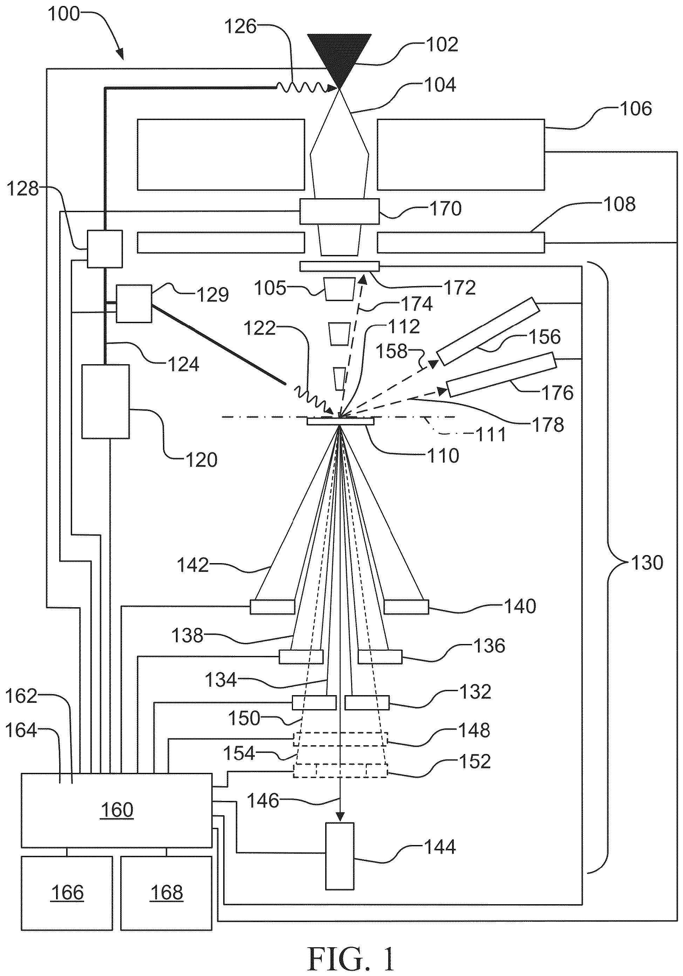

FIG. 1 illustrates an example of a CPM system 100 that may be used in conjunction with methods according to the present disclosure. As discussed below, the CPM system 100 may be described as representing an example of a SEM system and/or a STEM system. As shown in FIG. 1 the CPM system 100 includes a charged particle emitter 102 that produces a charged particle beam 104 and an optical assembly 106 that directs and/or focuses the charged particle beam 104 onto a sample test location 112 of a sample 110. In some examples, the charged particle emitter 102 is an electron emitter and the charged particle beam 104 is an electron beam. The sample 110 and/or the sample test location 112 can be positioned in a sample plane 111. The optical assembly 106 can include and/or be any of a variety of optical elements for manipulating the charged particle beam 104, such as an illuminator and/or a condenser system, and may include any suitable combination of electrostatic lenses, magnetic lenses, deflectors, correctors, etc.

The CPM system 100 additionally includes a scan coil 108 configured to scan the charged particle beam 104 relative to the sample 110 to bring the charged particle beam 104 to any of a variety of sample test locations 112 on the sample 110. The scan coil 108 also may be referred to as a deflector coil 108. In the present disclosure, the charged particle beam 104 may be described as illuminating the sample test location 112 when the charged particle beam 104 is incident upon the sample test location 112 to produce a response signal as described herein.

For simplicity, FIG. 1 illustrates potions of the charged particle beam 104 and corresponding signals downstream of the sample 110 in the form of continuous beam shapes. It is to be understood, however, that the present disclosure may relate to charged particle beams 104 and/or corresponding generated signals that are pulsed and/or otherwise discretized.

As shown in FIG. 1, the CPM system 100 includes an excitation source 120 that is configured to deliver and/or apply an excitation stimulus 122 to the sample test location 112. In some examples, the excitation source 120 includes and/or is a laser source and the excitation stimulus 122 is a laser beam and/or a laser pulse generated by the excitation source 120. In the example of FIG. 1, the CPM system 100 includes one or more waveguides 124 (e.g., optical fibers) configured and/or arranged to convey the excitation stimulus 122 toward and/or to the sample test location 112.

In some examples, the excitation source 120 is configured to apply the excitation stimulus 122 across a region of the sample 110 that encompasses multiple sample test locations 112. For example, the excitation stimulus 122 may be applied across a region of the sample 110 that includes a plurality of, or all of, the sample test locations 112 to be measured in a given experiment. Additionally, or alternatively, the excitation stimulus 122 may be applied to a portion of the sample 110 that does not encompass one or more of the sample test locations 112 to be measured. Accordingly, in various examples, the CPM system 100 may be configured such that the charged particle beam 104 is scanned relative to the sample 110 as the experiment moves to a new sample test location 112 without scanning the excitation stimulus 122 relative to the sample 110 in a similar manner.

Each sample test location 112 can be defined in any of a variety of manners. For example, each sample test location 112 can refer to a localized location, or point, on the sample 110 (e.g., on an upper surface of the sample 110). In such an example, a sample test area can include a plurality of spaced-apart sample test locations 112 arranged in a grid. In such examples, the charged particle beam 104 can be focused toward each sample test location 112 and may be incident upon the sample 110 with a beam width that encompasses the targeted sample test location 112. As another example, each sample test location 112 can refer to a two-dimensional region on the sample 110 (e.g., on the upper surface of the sample 110) such that neighboring sample test locations 112 are directly adjacent to one another. In such examples, the charged particle beam 104 can be focused toward each sample test location 112 with a beam width that is encompassed within the sample test location 112. In all such examples, the sample test locations 112 additionally or alternatively may be referred to as pixels 112 and/or as sample pixels 112.

While the present disclosure generally relates to examples in which the excitation stimulus 122 is a pulsed laser beam, this is not required of all examples. In other examples, the excitation source 120 additionally or alternatively may be configured to deliver any other suitable excitation to the sample test location 112. As examples, the excitation stimulus 122 can include and/or be a mechanical stimulus, a thermal stimulus, an electromagnetic stimulus (e.g., non-laser light), etc.

When the sample test location 112 is illuminated by the charged particle beam 104, the sample 110 can yield a variety of response signals, which may be detected and/or measured in a variety of manners. The CPM system 100 may include a detector subassembly 130 that includes one or more detectors for measuring such response signals. For example, and as shown in FIG. 1, the detector subassembly 130 may include a bright-field electron detector 132 configured to record a bright-field signal 134 emitted by the sample 110, an annular bright-field electron detector (e.g., the bright-field electron detector 132) configured to record an annular bright-field signal emitted by the sample 110 (e.g., at least a portion of the bright-field signal 134), an annular dark-field electron detector 136 configured to record an annular dark-field signal 138 emitted by the sample 110, and/or a high-angle annular dark-field electron detector 140 configured to record a high-angle annular dark-field signal 142 emitted by the sample 110. Additionally, or alternatively, the detector subassembly 130 may include an electron energy loss spectroscopy module 144 configured to record an electron energy loss spectroscopy signal 146. In all such examples, the signal that is recorded by each detector can include and/or be electrons that are emitted from the sample 110 in a downstream direction as a result of an interaction between the charged particle beam 104 and the sample test location 112.

Additionally, or alternatively, the detector subassembly 130 may include one or more electron detectors that are configured to record information regarding a spatial distribution of electrons that are emitted from the sample 110. For example, and as shown in FIG. 1, the detector subassembly 130 may include a pixelated electron detector 148 that includes a plurality (e.g., a grid) of detector pixels. Such a pixelated electron detector 148 may be configured to create a two-dimensional recording of the electrons that are emitted by the sample 110, such as an image of a spatial distribution of the electrons. In some examples, the pixels of the pixelated electron detector 148 may be configured to record the arrival times of electrons that are incident upon the pixels, the energies of the electrons incident upon the pixels, and/or a total number of electrons incident upon each pixel in a given unit of time. In some examples, the pixelated electron detector 148 may be configured to record a diffraction signal 150 (e.g., a diffraction pattern) emitted by the sample 110. In particular, in the example of FIG. 1, the diffraction signal 150 represents a convergent beam electron diffraction signal. Additionally, or alternatively, the pixelated electron detector 148 may be configured to record any other suitable form of electron signal emitted from the sample 110.

As another example, the detector subassembly 130 may include a segmented electron detector 152 with a plurality of detector segments. In such examples, the segmented electron detector 152 may be configured to record a differential phase contrast signal 154 that is emitted from the sample 110.

The detector subassembly 130 also may include one or more detectors to detect signals that are emitted in an upstream direction as a result of an interaction between the charged particle beam 104 and the sample test location 112. The use of such detectors may correspond to examples in which the CPM system 100 includes and/or is a SEM and/or examples in which the CPM system 100 includes and/or is a STEM. For example, and as shown in FIG. 1, the detector subassembly 130 may include a backscattered electron detector 172 configured to record a backscattered electron signal 174 emitted by the sample 110 and/or a secondary electron detector 176 configured to detect a backscattered electron signal 178 emitted by the sample 110.

In some examples, and as shown in FIG. 1, the signals emitted from the sample 110 additionally or alternatively may include electromagnetic radiation, such as an X-ray signal 158. Accordingly, the detector subassembly 130 may include an X-ray detector 156 configured to detect the X-ray signal 158. The X-ray signal 158 may include and/or be an energy-dispersive X-ray spectroscopy signal.

The various detectors and components of the detector subassembly 130 are provided as non-limiting examples, and it is to be understood that the CPM system 100 may include more or fewer detector components than those discussed herein. It further is to be understood that the CPM system 100 can include and/or use any suitable combination of such detector components.

As shown in FIG. 1, the CPM system 100 additionally may include a controller 160 that is configured and/or programmed to operate various components of the CPM system 100 as described herein. For example, the controller 160 may include a processor system 162 and a memory 164 that stores instructions that, when executed by the processor system 162, cause the controller 160 and/or the CPM system 100 to perform any of the applicable methods disclosed herein. The CPM system 100 additionally may include a user input device 166 for receiving an input from a user and/or a display device 168 for visually displaying information to the user.

The CPM system 100 may be configured to control the times at which the charged particle beam 104 and the excitation stimulus 122 are incident upon the sample test location 112 in any of a variety of manners. The interval of time separating the incidence time of the excitation stimulus 122 and the incidence time of the illuminating charged particle beam 104 upon the sample test location 112 can be referred to herein as a phase delay and/or as a time delay.

As described herein, the excitation stimulus 122 and the charged particle beam 104 each may be incident upon the sample test location 112 for a very short but nonzero duration. For example, the excitation stimulus 122 may include and/or be a pulse of laser light, and the charged particle beam 104 may be incident upon the sample test location 112 in the form of a pulse and/or train of charged particles (e.g., electrons). Accordingly, the excitation stimulus 122 (and/or portion thereof) that is incident upon the sample test location 112 for a given measurement also may be referred to herein as an excitation pulse 122. Similarly, the portion of the charged particle beam 104 that is incident upon the sample test location 112 for a given measurement may be referred to as an illumination pulse 105.

In some examples, each excitation stimulus 122 is incident upon the sample 110 for a duration that is less than 1 picosecond (ps). Additionally, or alternatively, in some examples, each illumination pulse 105 is incident upon the sample 110 for a duration that is less than 1 ps. In such examples, the excitation and/or illumination of the sample test location 112 may be described as occurring on a femtosecond time scale.

The phase delay separating the incidence of the excitation stimulus 122 and the charged particle beam 104 may be defined in any of a variety of manners. For example, the phase delay may be defined in terms of a time delay between the incidence of various portions of the excitation pulse 122 and the illumination pulse 105 upon the sample test location 112. As a more specific example, the phase delay may correspond to a time interval measured relative to the times at which each of the excitation pulse 122 and the illumination pulse 105 has a maximum intensity at the sample test location 112. Additionally, or alternatively, the phase delay may correspond to a time delay measured relative to the midpoints of the respective time intervals during which each of the excitation pulse 122 and the illumination pulse 1105 is incident upon the sample test location 112. As additional examples, the phase delay may correspond to a time interval measured relative to a time at which the excitation pulse 122 is first incident upon the sample test location 112, a time at which the excitation pulse 122 has a maximum intensity at the sample test location 112, and/or a time at which the excitation pulse 122 is last incident upon the sample test location 112. Additionally, or alternatively, the phase delay may correspond to a time interval measured relative to a time at which the illumination pulse 105 is first incident upon the sample test location 112, a midpoint of a time interval in which the illumination pulse 105 is incident upon the sample test location 112, and/or a time at which the illumination pulse 105 is last incident upon the sample test location 112.

The CPM system 100 may be configured to generate the illumination pulses 105 of the charged particle beam 104 in any of a variety of manners. For example, as shown in FIG. 1, the CPM system 100 may include a radio frequency (RF) cavity 170 configured to generate a pulsed charged particle beam through an interaction between one or more RF standing waves and a passing charged particle beam (e.g., the charged particle beam 104). Though not specifically illustrated as such in FIG. 1 it is to be understood that the RF cavity 170 may be located at a crossover plane of the charged particle beam 104 downstream of the charged particle emitter 102.

In some examples, the RF cavity 170 can include input and output apertures that allow the charged particle beam 104 to traverse the RF cavity 170 so that the charged particle beam interacts with the RF waves established within the cavity. In other examples, a "chopping aperture" may be arranged away from the RF cavity 170. In such examples, the charged particle beam 104 can interact with the RF waves within the RF cavity 170 to yield a periodic deflection of the charged particle beam 104 that causes the creation of the illumination pulses 105 at the chopping aperture. In all such examples, the spatial and/or temporal interactions between the aperture, the RF standing wave(s), and the charged particle beam 104 can form the illumination pulses 105. In such examples, the RF waves can effectively move the charged particle beam across the output aperture so that a pulsed train of electrons are emitted and directed toward the sample 110. Examples of RF cavities that may be used in conjunction with the CPM system 100 are disclosed in U.S. Patent No. 9,048,060, which is incorporated by reference herein for all purposes.

As another example, the illumination pulses 105 may be generated at the charged particle emitter 102. For example, and as shown in FIG. 1, a portion of the laser pulse generated by the excitation source 120 may be conveyed toward the charged particle emitter 102 (e.g., by the waveguide 124) in the form of an emitter pulse 126. The emitter pulse 126 then may be incident upon a portion of the charged particle emitter 102 to stimulate emission of the charged particle beam 104 in the form of an illumination pulse 105. Thus, in such examples, generating a series of excitation pulses 122 with the excitation source 120 can operate to generate a corresponding series of illumination pulses 105 with the charged particle emitter 102. In such examples, the charged particle emitter 102 also may be referred to as a photoelectron induced charged particle emitter 102. In some such examples, the CPM system 100 additionally includes a variable illumination delay line 128 in line with the waveguide 124 between the excitation source 120 and the charged particle emitter 102 that is configured to delay transmission of the illumination pulse 105 by a variable degree. Accordingly, in such examples, varying the delay generated by the variable illumination delay line 128 (e.g., with the controller 160) can operate to vary the phase delay at the sample test location 112.

As yet another example, the pulsing of the charged particle beam 104 may be achieved via fast beam blanking, such as using a beam blanker of the optical assembly 106.

In all such examples, the controller 160 may at least partially control the generation and/or pulsing of the charged particle beam 104. For example, the controller 160 may directly control operation of the charged particle emitter 102 to yield a continuous charged particle beam 104, and/or may directly control operation of the RF cavity 170 to yield the illumination pulses 105. As another example, the controller 160 may control operation of the excitation source to generate the emitter pulses 126 that are used in conjunction with a photoelectron induced charged particle emitter 102.

While FIG. 1 illustrates an example in which the RF cavity 170 operates upon an input charged particle beam 104 to generate the illumination pulses 105, it is to be understood that the illumination pulses 105 downstream of the RF cavity 170 also may be referred to (individually and/or collectively) as the charged particle beam 104. Similarly, in an example in which the charged particle emitter 102 emits the charged particle beam 104 in the form of a series of illumination pulses 105, such illumination pulses 105 may be referred to (individually and/or collectively) as the charged particle beam 104. Additionally, while FIG. 1 illustrates an example in which the excitation stimulus 122 is the excitation pulse 122, it is to be understood that the excitation pulse 122 also may refer to a portion of an excitation stimulus that includes a plurality of such pulses.

In some examples, the pulsing of the charged particle beam 104 is synchronized with the scanning of the charged particle beam 104 (and/or of the illumination pulses 105) relative to the sample 110. As described in more detail herein, such synchronization can result in an equal number of illumination pulses 105 being delivered to each sample test location 112.

The CPM system 100 may be configured to control and/or measure the phase delay in any of a variety of manners. For example, and as shown in FIG. 1, the CPM system 100 may include a variable excitation delay line 129 in line with the waveguide 124 between the excitation source 120 and the sample 110 that is configured to delay transmission of the excitation pulse 122 by a variable degree. Accordingly, in such examples, varying the delay generated by the variable excitation delay line 129 (e.g., with the controller 160) can operate to vary the phase delay at the sample test location 112.

Additionally, or alternatively, the phase delay may be at least partially controlled via synchronization of the generation of the excitation pulse 122 with operation of the RF cavity 170. For example, the controller 160 may be programmed and/or configured to coordinate the generation of the excitation pulse 122 by the excitation source 120 and the generation of the illumination pulses 105 by the RF cavity 170 such that the illumination pulses 105 are delayed relative to the excitation pulses 122 by a controlled phase delay.

Whie the present disclosure generally relates to examples in which the sample 110 is stroboscopically probed with discrete illumination pulses 105, this is not required of all examples. For example, as discussed above, the pixelated electron detector 148 (and/or another component of the detector subassembly 130) may be configured to record the arrival time of electrons. In such examples, the charged particle beam 104 may be directed to the sample test location 112 over an illumination time interval to yield a response signal over a corresponding time interval. A portion of the response signal that is delayed relative to the excitation stimulus 122 by a given phase delay may then be identified and recorded as the response signal corresponding to that phase delay. Such a method may enable identification of the desired response signal with a high degree of precision. In some examples, however, the time needed to reset the detector for a subsequent measurement may be relatively lengthy.

In the present disclosure, references to performing a test measurement with a particular phase delay, such as using an appropriately timed illumination pulse, may be understood as encompassing examples in which the measured signal is extracted from an extended measurement duration as described above. That is, while the present disclosure generally relates to examples in which the phase delay is controlled through the generation of the illumination pulse, the principles of the present disclosure equivalently may be applied to examples in which the phase delay corresponds to a selected portion of a time-stamped continuous recording.

The full data set generated via an experiment according to the present disclosure may be described as a multidimensional data set on the basis of the number of parameters and/or dimensions characterizing each data point. For example, a given data point of the data set may be characterized by each of the two spatial dimensions of the corresponding sample test location 112, the temporal dimension of the phase delay used in the measurement of the data point, and the number of dimensions characterizing the measurement of the response signal.

As a more specific example, when the recorded response signal is a measurement of a two-dimensional diffraction pattern (e.g., as record via the pixelated electron detector 148) corresponding to each sample test location 112, the resulting data set may be described as a five-dimensional data set. If such a data set is extended to additionally record a high-angle annular dark-field signal with the high-angle annular dark-field electron detector 140, the resulting data set may be described as a six-dimensional data set. Accordingly, in various examples, the resulting data set may be described as having a dimensionality of 3+N, where N represents the total dimensionality of the recorded response signals.

In general, performing a time-resolved experiment across an area of the sample 110 with the CPM system 100 can include the selection and/or coordination of several variables to be varied during the course of the experiment. Examples of such variables include the location (e.g., coordinates) of the sample test location 112 being probed at each test location measurement, the number of test location measurements that are performed at each sample test location 112 (and/or the sequence thereof), and the phase delay with which each test location measurement is performed.

In some prior examples, an experiment may be performed by, at each sample test location, performing a series of test location measurements with each of a plurality of different phase delays prior to transitioning to the next sample test location. In such a "pixel-based" approach, the full experiment may be complete when all sample test locations have been visited, since a full time-resolved data set will have been collected at each sample test location. Such an approach, however, can effectively obscure and/or delay various indications of the progress of the experiment until completion of the experiment, at which point various errors in the experiment may finally be revealed. For example, if the sample drifts relative to the charged particle beam by a substantial degree during the course of the experiment, or if the selected sample test region contains imperfections, the resulting data set that is revealed after a lengthy experiment may be undesirable or unusable. Similarly, performing repeated measurements at each sample test location can yield increasing damage of the sample by the charged particle beam, which may not be apparent until completion of the experiment a long time afterward. As another example, in the event that various sub-optimal experimental parameters have been used (e.g., beam current, focus plane, degree of optical aberrations, etc.), the detection or correction of such issues may be delayed until the completion of the full experiment.

By contrast, the methods of the present disclosure can result in an experimental procedure that yields useful and/or actionable information before completion of the full experiment. Accordingly, such methods can allow for the acquisition of a useful data set without requiring the iterative performance of a lengthy experiment. Such methods also can allow for the generation of preliminary data sets and/or representations of the sample prior to collecting a full experimental data set.

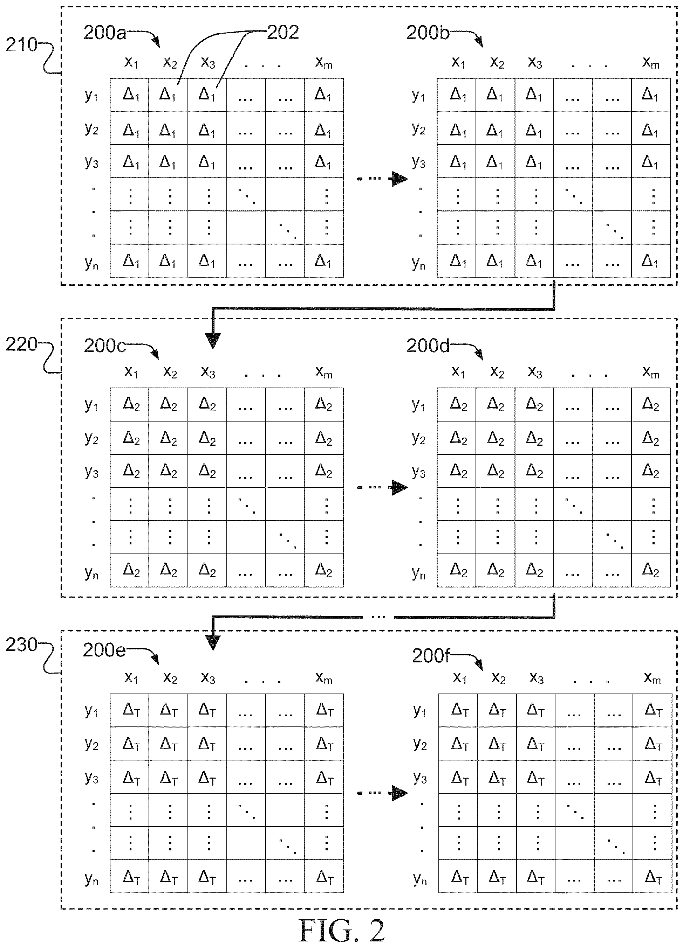

FIG. 2 represents an example of a sequence of measurements that can be performed to yield a data set corresponding to a region of a sample. FIG. 2 illustrates a series of data frames 200a-200f that may be recorded to form at least a portion of the data set. Each data frame 200a-200f includes data corresponding to each of a plurality of sample test locations 202, each of which may be described in terms of coordinates (*xᵢ, yⱼ*), where *i* = 1, 2, 3, ... , m and *j =* 1, 2, 3, ..., n.

As shown in FIG. 2, each sample test location 202 of each data frame 200a-200f may be characterized in terms of the phase delay Δ*ₖ* that is used to perform the corresponding test measurement. Each phase delay Δ*ₖ* may be identified via an index *k =* 1, 2, 3, ... , *T* such that the full set of phase delays Δ*ₖ* spans a range from a minimum phase delay Δ₁ to a maximum phase delay Δ*_{T}.* In this manner, the value of the index *T* may be understood as representing a resolution with which phase delays in this range are sampled. As a simplified example, a range of phase delays characterized by a minimum phase delay of 0 s, a maximum phase delay of 100 ps, and *T* = 101 phase delays to be sampled can include the phase delays Δ₁ = 0 s, Δ₂ = 1 ps, Δ₃ = 2 ps, ... , Δ*_{T}* = 100 ps.

In various examples, it may be desirable to configure the set of phase delays Δ*ₖ* to include a phase delay corresponding to a baseline test measurement, such as to determine whether the sample has exhibited spatial drift and/or temporal drift (e.g., temporal instability) over the course of an experiment. For example, it may be desirable to configure the set of phase delays Δ*ₖ* to include one or more negative phase delays (that is, corresponding to an illumination pulse that arrives before the excitation pulse) to provide such a baseline test measurement. Additionally, or alternatively, a test measurement may be performed with zero delay between the excitation pulse and the illumination pulse, which in some examples may represent such a baseline test measurement. In some examples, the baseline test measurement may correspond to the first phase delay tested (e.g., Δ₁), but this is not required. It is to be understood that the set of phase delays Δ*ₖ* can include any set of phase delays, including sets that do not include negative and/or zero phase delays.

In various examples, it may be desirable to configure the set of phase delays Δ*ₖ* such that the phase delays are evenly spaced; for example, such that Δ_{*i*+1} - Δ*ᵢ* is a constant for *i =* 1, ... , *T* - 1. In particular, probing a linear series of phase delays in this manner may be most practically straightforward to implement, and/or may offer evenly distributed sampling of a time interval of interest. This is not required of all examples, however. For example, it also is within the scope of the present disclosure that the phase delays may be non-linearly distributed. As a more specific example, it may be desirable to configure the set of phase delays Δ*ₖ* to be logarithmically distributed, such as to probe the dynamics around a phase delay range of interest (e.g., near zero phase delay) with greater resolution than longer phase delays that are farther from the range of interest. Additionally, or alternatively, configuring the set of phase delays to be logarithmically distributed can facilitate probing a wide range of time scales if a characteristic time scale of interest is initially unknown.

While the present disclosure generally relates to examples in which the set of phase delays Δ*ₖ* are tested sequentially (e.g., in sequence of increasing or decreasing values), this is not required of all examples. For example, in some examples, it may be desirable to probe the phase delays in a non-sequential order, such as in a random or pseudo-random order with respect to the values of the phase delays. In particular, such a configuration may facilitate distinguishing the actual dynamics of the sample response from an unrelated drift in the signal that otherwise may be inadvertently correlated with sequentially-tested phase delay values.

In the example of FIG. 2, the plurality of data frames 200a-200f are recorded in sequence, as indicated via flow arrows. As indicated with the ellipses in selected flow arrows, additional data frames also may be recorded in this sequence between the data frames shown. For example, any number of data frames similar to the data frames 200a and 200b may be recorded between the recordings of the data frames 200a and 200b.

For each data frame 200a-200f, a test location measurement is made at each sample test location 202 by applying an excitation stimulus (e.g., the excitation pulse 122 of FIG. 1) to the sample test location at a stimulus time and directing a charged particle beam (e.g., the illumination pulse 105 of FIG. 1) to the sample test location at a probe time. The probe time is separated from the stimulus time by a phase delay that corresponds to (e.g., is assigned to) the sample test location being tested and to the data frame being recorded. One or more response signals that are generated via an interaction between the charged particle beam and the sample are then recorded, such as with one or more components of the detector subassembly 130 of FIG. 1.

In some examples, one or more of the data frames 200a-200f may be recorded by performing repeated consecutive test location measurements (e.g., with multiple excitation pulses and/or multiple illumination pulses) at each sample test location before proceeding to the following sample test location.

In other examples, one or more of the data frames 200a-200f may be recorded by performing only a single test location measurement (e.g., with a single excitation pulse and a single illumination pulse) at each sample test location before proceeding to the following sample test location. In such examples, for all of the test location measurements performed in a given data frame, consecutive test location measurements may be performed at different sample test locations.

In all examples, the number of consecutive test location measurements performed at each sample test location may be at least partially determined and/or controlled by synchronizing the scan of the charged particle beam across the sample to the generation of the excitation pulses and/or the illumination pulses. For example, such synchronization can result in the same number (e.g., one or more) of excitation pulse/illumination pulse pairs being delivered to each sample test location.

In the example of FIG. 2, the data frame 200a is recorded using the same (single) phase delay Δ₁ at each sample test location 202. In particular, in this example, a plurality of such data frames are sequentially recorded using the same phase delay Δ₁ at each sample test location 202, with the data frame 200a representing the first data frame in this sequence and the data frame 200b representing the last data frame in this sequence.

With reference to the sequence of data frames including the data frames 200a and 200b, each sample test location of each data frame in this sequence may be described as a repeated sample test location. Specifically, in the present disclosure, the term "repeated sample test location" refers to any sample test location at which different, non-consecutive test location measurements are performed with the same repeated phase delay. In this example, the non-consecutive test location measurements correspond to the test location measurements that are performed in different data frames.

It is to be understood, however, that this definition of a repeated sample test location does not preclude the possibility that such sample test locations also can be tested with the same repeated phase delay in consecutive test location measurements. This may be the case, for example, when a plurality of illumination pulses are applied to each sample test location in a given data frame before progressing to a subsequent sample test location of the data frame.

The data frames 200a-200b (and any similarly recorded intermediate data frames not shown in FIG. 2) may be described herein as representing phase-redundant data frames. Specifically, as used herein, the term "phase-redundant data frames" may be used to refer to any set of data frames in which, for each sample test location, the test location measurement is performed with the same phase delay in each of the phase-redundant data frames. For example, with reference to the data frames 200a and 200b, the same phase delay is used at the sample test location (*x*₁, *y*₁) in each data frame, the same phase delay is used at the sample test location (*x*₂, *y*₁) in each data frame, and so forth for all sample test locations. In other examples, and as discussed in more detail below, a set of phase-redundant data frames can include data frames in which different phase delays are used at different sample test locations within the data frame. In the example of FIG. 2, the sequence of phase-redundant data frames including the data frames 200a and 200b may be referred to as a first set 210 of phase-redundant data frames.

Following the recording of the data frame 200b, the data frame 200c may be recorded, in which the same phase delay Δ₂ is used at each sample test location 202. A plurality of such data frames may then be sequentially recorded using the same phase delay Δ₂ at each sample test location, with the data frame 200c representing the first data frame in this sequence and the data frame 200d representing the last data frame in this sequence. The data frames 200c-200d (and any similarly recorded intermediate data frames not shown in FIG. 2) thus also may be described as representing a set of phase-redundant data frames. In particular, in this example, the sequence of phase-redundant data frames including the data frames 200c and 200d may be referred to as a second set 220 of phase-redundant data frames.

This sequence may be repeated for each phase delay Δ*ₖ* to be considered. In FIG. 2, the data frames 200e and 200f respectively represent the first and last data frames recorded using the same final phase delay Δ*_{T}.* The data frames 200e-200f (and any similarly recorded intermediate data frames not shown in FIG. 2) thus also may be described as representing a third set 230 of phase-redundant data frames. In the example of FIG. 2, the third set 230 of phase-redundant data frames represents the last of *T* different sets of phase-redundant data frames that are recorded.

The number of phase-redundant data frames recorded for each phase delay being tested may be at least partially based on the number of test location measurements that are performed at each sample test location of each data frame. For example, for a given sample test location and a given phase delay that are to be tested, a complete characterization of the sample test location at that phase delay may require supplying at least a threshold illumination flux to the sample test location via the illumination pulses. Stated differently, each illumination pulse may generate a response signal that is too faint to be detected with a usable signal-to-noise ratio (SNR), such that a usable signal may be acquired only by generating a series of response signals with a series of illumination pulses until the total measured signal has a sufficient SNR. The threshold illumination flux can represent the total illumination that yields such a total measured signal.

The threshold illumination flux may be distributed among various test location measurements in any of a variety of manners. For example, increasing the number of test location measurements that are performed at each sample test location in a given data frame can allow for a corresponding decrease in the number of phase-redundant data frames that need to be recorded (and vice-versa).

Recording a relatively large number of phase-redundant data frames in which a relatively small number of test location measurements (e.g., one test measurement) are performed at each sample test location can result in each data frame being recorded in a relatively short period of time. In some examples, while each data frame may not contain sufficient data to fully characterize the scanned region of the sample (e.g., with a sufficient SNR), each data frame (or a small collection thereof) still may contain sufficient data to provide valuable information regarding the status of the experiment.

For example, any one (or more) of the data frames 200a-200f represented in FIG. 2 may be analyzed to yield intermediate information regarding the status of the experiment. Examples of such intermediate information include information regarding a spatial drift of the sample during the experiment, whether the beam current of the charged particle beam is too low to generate a meaningful response signal, whether the beam current of the charged particle beam is too high to avoid damaging the same, whether the charged particle beam is properly focused upon the sample, whether the scanned region of the sample is suitable for testing, etc. In some examples, two or more data frames may be combined (e.g., by summing and/or integrating the respective measured response signals at each sample test location) to yield such intermediate information. For example, two or more phase-redundant data frames may be combined to yield higher-quality information regarding the response signal at each sample data location with each corresponding phase delay. As another example, two or more non-phase-redundant data frames may be combined to yield intermediate information regarding other aspects of the sample behavior, such as sample drift. In all such examples, the data frames that are analyzed to yield such intermediate information may be referred to as test data frames.

In some examples, the intermediate information can be included in, represented as, and/or derived from an intermediate representation of the sample. For example, one or more data frames may be recorded, rendered, and/or displayed as an image that represents the scanned area of the sample. An analysis of such an image may yield the intermediate information. For example, analysis of such an image may yield information regarding a spatial drift of the sample, information regarding regions of the sample that are damaged, and/or information regarding whether different experimental parameters (e.g., beam current, focus location, etc.) would be preferable.

In various examples, the intermediate representation may be described as an image even when such an image is not graphically rendered and/or displayed. For example, the intermediate representation may be recorded and/or stored as a data file (e.g., an image data file) that is analyzed by a computer processor (e.g., of the controller 160). In other examples, the intermediate representation may be graphically displayed to a user who can then derive meaningful information from the displayed representation and optionally adjust the experiment accordingly.

In an example in which an analysis of one or more test data frames yields an indication that the experiment is suffering from shortcomings such as those listed above, the experimental parameters may be adjusted accordingly prior to completing the experiment. In some examples, such adjustments may be made at least partially in response to a user input. For example, the intermediate representation may be displayed to a user (e.g., using the display device168 of FIG. 1), and the user may adjust one or more experimental parameters based on the intermediate representation (e.g., using the user input device 166 of FIG. 1). Additionally, or alternatively, the adjustments may be performed at least partially automatically, such as by the controller 160 of FIG. 1.

The data contained in a set of phase-redundant data frames may be combined and/or aggregated to yield an enhanced response signal measurement corresponding to each repeated sample test location. For example, for each sample test location, the recorded response signals measured in each data frame of a given set of phase-redundant data frames collectively may form an aggregated data set corresponding to the repeated phase delay used in each such measurement. The aggregated data set may then be contracted, such as by summing and/or integrating the individual recorded response signals, to yield an aggregated data point corresponding to the selected sample test location and the corresponding phase delay. In this manner, the aggregated data point may offer an improved SNR relative to the individual recorded response signal represented by each individual data frame. The aggregated data point may be described as being "contracted" relative to the aggregated data set in the sense that the several data points of the aggregated data set are condensed into a single corresponding aggregated data point. The aggregated data point can include and/or refer to data of any dimensionality, such as a (one-dimensional) intensity measurement, a (two-dimensional) diffraction pattern, etc.

In the example of FIG. 2, various combinations of data frames additionally may be described as representing sets of phase-varying data frames. Specifically, as used herein, the term "phase-varying data frames" may be used to refer to any set of data frames in which, for each sample test location, the test location measurement is performed with a different phase delay in each of the phase-varying data frames. For example, with reference FIG. 2, the phase delay used at each sample test location in the data frame 200a is different than the phase delay used at the same sample test location in the data frame 200c. Similarly, the phase delay used at each sample test location in the data frame 200c is different than the phase delay used at the same sample test location in the data frame 200e. Accordingly, the data frames 200a, 200c, and 200e may be described as representing a set of phase-varying data frames.

The example of FIG. 2 thus may be described as an example in which a multidimensional data set is collected by recording a plurality of sequences of phase-redundant data frames, with each sequence corresponding to a different phase delay that is used at each sample test location. Each sequence of phase-redundant data frames can then be aggregated to yield an aggregated data point corresponding to each sample test location and to the phase delay used at that sample test location in each data frame. By repeating this procedure for each sequence of phase-redundant data frames, each sample test location can be associated with an aggregated data point corresponding to each phase delay in the range of phase delays that were tested.

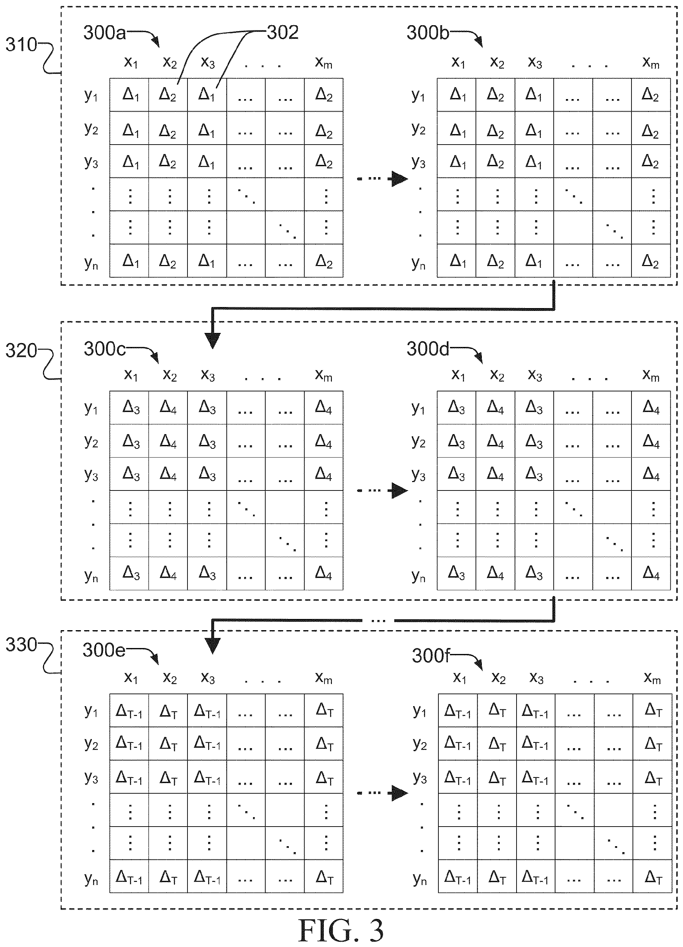

In the example of FIG. 2, each data frame 200a-200f is recorded such that each sample test location 202 represented in the data frame is tested with the same phase delay. This is not required of all examples, however. For example, FIG. 3 illustrates another example of a sequence of measurements that can be performed to yield a data set corresponding to a region of a sample. FIG. 3 illustrates a series of data frames 300a-300f that may be recorded to form at least a portion of the data set. Each data frame 300a-300f includes data corresponding to each of a plurality of sample test locations 302, each of which may be described in terms of coordinates (*xᵢ, yⱼ*), where *i* = 1, 2, 3, ..., *m* and *j* = 1, 2, 3, ... , *n.*

Similar to FIG. 2, the plurality of data frames 300a-300f includes a first set 310 of phase-redundant data frames that includes the data frames 300a and 300b, a second set 320 of phase-redundant data frames that includes the data frames 300c and 300d, and a third set 330 of phase-redundant data frames that includes the data frames 300e and 300f.

In the example of FIG. 3, each data frame 300a-300f includes sample test locations 302 at which test location measurements are performed with different phase delays. Specifically, in this example, each data frame represents test location measurements performed with two different phase delays. In each data frame 300a-300f, the sample test locations (*xᵢ, yⱼ*) where *i* is odd may be described as forming a first location subset, and the sample test locations (*xᵢ, yⱼ*) where *i* is even may be described as forming a second location subset. (For simplicity, this example treats the index m as an even integer; however, this is not required.)

In each data frame 300a-300f, each sample test location in the first location subset is measured with a first phase delay, and each sample test location in the second location subset is measured with a second phase delay. Within each set of phase-redundant data frames (e.g., within the first set 310, the second set 320, or the third set 330), the first phase delay is the same phase delay for each data frame in the set, and the second phase delay is the same phase delay for every data frame in the set.

Comparing data frames from different sets of phase-redundant data frames, however, it may be seen that the first (or second) phase delay for one such data frame is different than the first (or second) phase delay for another such data frame. In this manner, selected data frames from different sets of phase-redundant data frames may be described as forming a set of phase-varying data frames as described above.

For each data frame in the example of FIG. 3, the sample test locations of the first location subset may be described as being interlaced with the sample test locations of the second location subset. The set of data captured in any such data frame (or the aggregated data points of a collection of phase-redundant data frames) may be described as being analogous to a set of data collected in two different data frames, each of which is recorded with a single phase delay at each sample test location and with half the spatial resolution. In this manner, using different phase delays at different sample test locations (or subsets of sample test locations) can yield information corresponding to multiple different phase delays in a single scan of the sample area, with the tradeoff of a diminished spatial resolution. For example, it may be desirable to test a plurality of different phase delays in a rapid manner to determine whether such phase delays are appropriate to the dynamical process being probed prior to performing a full experiment. In such examples, the diminished spatial resolution that may result from interleaving phase delays in the manner of FIG. 3 may be inconsequential relative to the information gained toward confirming and/or calibrating the experimental parameters in an early stage of an experiment.

While FIG. 3 illustrates an example in which the first location subset and the second location subset are interleaved with one another, this is not required. In other examples, the first location subset and the second location subset can correspond to any other non-overlapping subsets of the sample test locations. Additionally, or alternatively, the sample test locations can include any other suitable number (e.g., three, four, or more than four) of test location subsets with corresponding phase delays. The test location subsets can encompass the same number of sample test locations or different numbers of sample test locations.

In various examples, the manner in which each sample test location is associated with a corresponding phase delay in a given data frame may be described as representing a phase mapping of the data frame. Thus, for example, every data frame in a given set of phase-redundant data frames may be described as being characterized by the same phase mapping. Similarly, each data frame in a given set of phase-varying data frames may be described as being characterized by a different phase mapping.

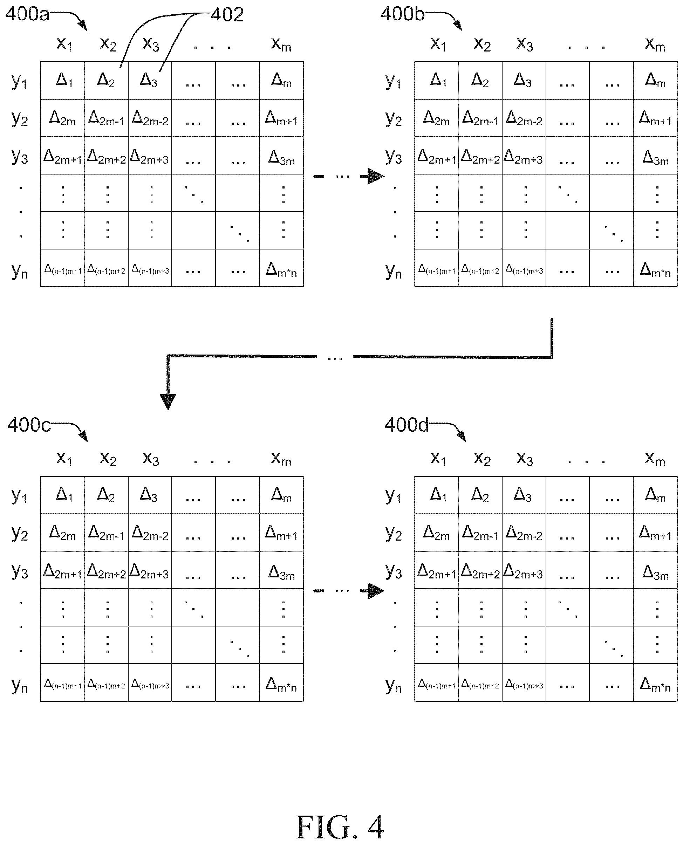

FIG. 4 illustrates another example of a sequence of measurements that can be performed to yield a data set corresponding to a region of a sample. FIG. 4 illustrates a series of data frames 400a-400d that may be recorded to form at least a portion of the data set. Each data frame 400a-400d includes data corresponding to each of a plurality of sample test locations 402, each of which may be described in terms of coordinates (*xᵢ, yⱼ*), where *i* = 1, 2, 3, ... , *m* and *j =* 1, 2, 3, ..., *n.*

In the example of FIG. 4, each data frame 400a-400d is characterized by the same phase mapping. Accordingly, the data frames 400a-400d may be described as representing a set of phase-redundant data frames. Additionally, in this example, the phase mapping is characterized by the feature that different phase delays are used at each sample test location 402.

Because each sample test location in the example of FIG. 4 is tested only at a single phase delay, the resulting data set does not contain the same information as in the examples of FIGS. 2-3, in which each sample test location is tested at a plurality of different phase delays. Capturing one or more data frames in the manner of FIG. 4 still may be valuable, however, such as to test a wide range of phase delays in a relatively short period of time. For example, the range of phase delays used in each data frame 400a-400d may be sufficiently wide to encompass a dynamic process that occurs in an unknown time scale. In such an example, one or more of the data frames 400a-400d may (individually and/or in aggregate) provide an indication of a characteristic time scale that can be probed more precisely in a subsequent experiment.

In another example, the measurement sequence depicted in FIG. 4 may be varied by varying the phase mapping of one or more of the data frames 400a-400d such that each sample test location 402 is tested with different phase delays in two or more different data frames. For example, the phase mappings may be adjusted such that each data frame represents the same set of phase delays, which are distributed among the sample test locations in different manners to yield phase-varying data frames. In such an example, recording a sufficient number of such phase-varying data frames (and/or a sufficient number of phase-redundant data frames for each individual phase mapping) may yield sufficient data to form a full experimental data set. In some examples, the set of data frames in which a given sample test location is measured with the same phase delay may be different for each sample test location and/or for each phase delay. Thus, in general, it may be desirable to assign to each recorded response signal a metadata label that represents the data frame, the sample test location, and/or the phase delay corresponding to the recorded response signal. This may enable the identification of all recorded response signals that correspond to a given sample test location and/or to a given phase delay, regardless of the sequence in which the corresponding measurements were made.

In the examples of FIGS. 2-4, flow arrows are provided to indicate an example of a sequence in which the depicted data frames may be recorded. It is to be understood, however, that such sequences are not required, and that an equivalent data set may be acquired by recording the data frames in any other sequence. Accordingly, unless stated otherwise, references herein to recording a specified plurality of data frames do not require that such data frames be recorded in consecutive sequence.

FIGS. 2-4 generally depict examples in which a test location measurement is performed at every sample test location for each data frame. This is not required of all examples, however. For example, it also is within the scope of the present disclosure that one ore more data frames may be recorded in a "sparse" manner in which test location measurements are performed at some but not all of the sample test locations. In some such examples, a plurality of data frames may be recorded such that a test location measurement is performed at each sample test location in some but not all of the data frames.

Additionally, or alternatively, the set of sample test locations at which sample test location measurements are performed in at least one data frame may be distributed sparsely within a region of the sample. Stated differently, in some examples, the set of sample test locations may be selected such that test location measurements are not performed within various regions of the sample adjacent to and/or between the selected sample test locations.

In various examples, the phase delays similarly may be probed in a sparse manner. For example, while FIGS. 2-4 generally depict examples in which phase delays are probed sequentially (e.g., between adjacent sample test locations within a given data frame and/or between the same sample test location in sequentially recorded data frames), this is not required of all examples. In other examples, and as discussed above, the phase delays may be probed in a random or pseudo-random sequence within a given data frame and/or between sequentially recorded data frames.

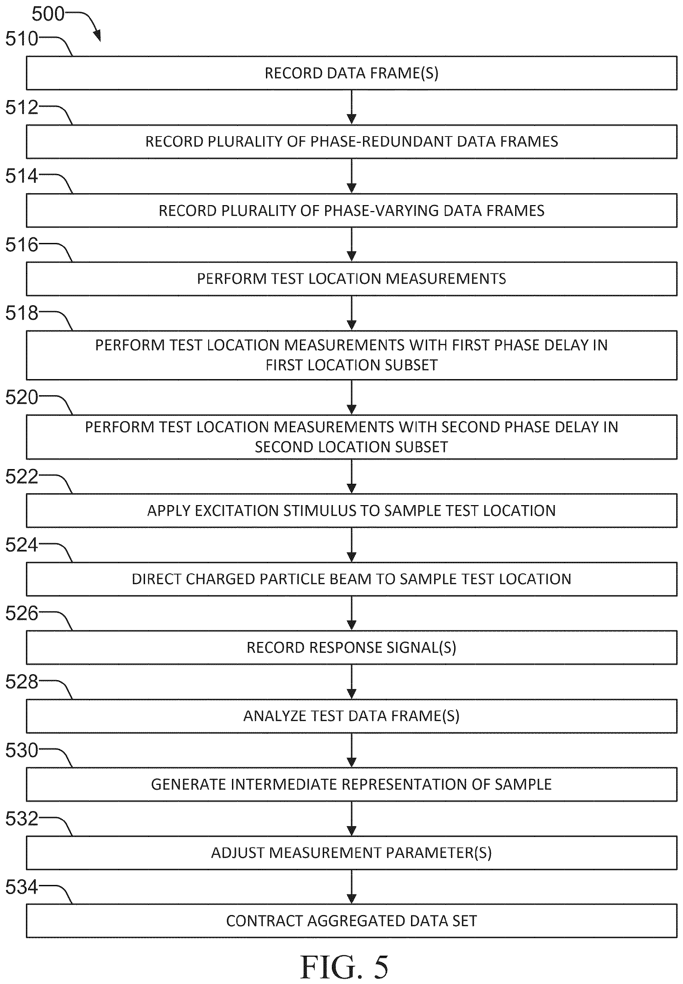

FIG. 5 is a flowchart depicting examples of a method 500 of collecting a data set. Unless otherwise specified, each component, feature, attribute, etc. described herein with reference to the method 500 may be understood as referring to and/or encompassing similarly named components, features, attributes, etc. that are discussed herein with reference to any of FIGS. 1-4. The method 500 and/or any suitable portion thereof may be performed by a computer processor system, such as by one or more processors of the controller 160 of FIG. 1.

As shown in FIG. 5, the method 500 includes recording, at 510, one or more data frames. For each data frame of the one or more frames, the recording the data frame(s) at 510 can include performing, at 516, a test location measurement at each sample test location of a plurality of sample test locations.

For each sample test location, the performing the test location measurement at 516 can include applying, at 522, an excitation stimulus to the sample test location at a stimulus time and directing, at 524, a charged particle beam to the sample test location at a probe time. The probe time is separated from the stimulus time by a phase delay. For each sample test location, the performing the test location measurement at 516 additionally can include recording, at 526, one or more response signals that are generated via an interaction between the charged particle beam and the sample. The charged particle beam may include and/or be a charged particle beam, such as the charged particle beam 104 generated by the CPM system 100 of FIG. 1.

The performing the plurality of test location measurements at 516 may be performed in any of a variety of manners. In some examples, the performing the test location measurement at 516 is performed such that the plurality of sample test locations forms a two-dimensional grid of locations on the sample.

In some examples, the performing the test location measurement at 516 is performed such that the test location measurements are synchronized with the scanning of the charged particle beam relative to the sample. Specifically, in some examples, the method 500 incudes scanning the charged particle beam relative to the sample to direct the charged particle beam to each sample test location and synchronizing the scanning of the charged particle beam with the performing the test location measurement at 516. Such synchronization may be performed such that the same number of test location measurements are performed at each sample test location before progressing to the subsequent sample test location. More specifically, the directing the charged particle beam at 524 can include directing an illumination pulse to the sample test location, and the synchronizing can include directing the same number of illumination pulses to each sample test location.

As discussed above in the context of FIG. 1, the applying the excitation stimulus at 522 may include applying the excitation stimulus to a region of the sample that encompasses a plurality of sample test locations, such as all of the plurality of sample test locations. In some examples, the applying the excitation stimulus at 522 includes directing a laser pulse to the sample, such as a femtosecond laser pulse that is incident upon the sample for a duration that is less than 1 ps.

In some examples, the directing the charged particle beam at 524 includes directing a charged particle beam pulse (e.g., an illumination pulse) to the sample test location. For example, the charged particle beam pulse may be incident upon the sample for a duration that is less than 1 ps.

The recording the response signal(s) at 526 may include recording any of a variety of signals with any of a variety of detectors. As examples, the recording the response signal(s) at 526 may include recording a bright-field signal and/or an annular bright-field signal (e.g., with the bright-field electron detector 132 of FIG. 1), recording an annular dark-field signal (e.g., with the annular dark-field electron detector 136 of FIG. 1), recording a high-angle annular dark-field signal (e.g., with the high-angle annular dark-field electron detector 140 of FIG. 1), recording a backscattered electron signal (e.g., with the backscattered electron detector 172 of FIG. 1), recording a secondary electron signal (e.g., with the secondary electron detector 176 of FIG. 1), recording an energy-dispersive X-ray spectroscopy signal (e.g., with the X-ray detector 156 of FIG. 1) recording an electron energy loss spectroscopy signal (e.g., with the electron energy loss spectroscopy module 144 of FIG. 1), recording a differential phase contrast signal (e.g., with the segmented electron detector 152 of FIG. 1), and/or recording a convergent beam electron diffraction signal (e.g., with the pixelated electron detector 148 of FIG. 1).

In various examples, the recording the response signal(s) at 526 includes recording signal corresponding to two or more different analytical methodologies, such as by using two or more separate detector devices. As an example, the response signals that are recorded in each test location measurement can include an electron energy loss spectroscopy signal that is recorded by an electron energy loss spectroscopy module as well as an annular signal that is recorded by an annular STEM detector (e.g., a bright-field electron detector, an annular dark-field electron detector, and/or a high-angle annular dark field electron detector). As another example, the response signals that are recorded in each test location measurement can include an energy-dispersive X-ray spectroscopy signal that is recorded with an X-ray detector as well as a backscattered electron signal that is recorded with a backscattered electron detector and/or a secondary electron signal that is recorded with a secondary electron detector. As another example, the response signals that are recorded in each test location measurement can include an electron diffraction pattern that is recorded by a pixelated electron detector as well as a high-angle annular dark field signal that is recorded by a separate high-angle annular dark field electron detector. Any other practical combinations of signals and/or detectors also are within the scope of the present disclosure. In such examples, the test location measurements may be described as being multimodal measurements. As a result, the data set resulting from the performance of the method 500 may have a dimensionality of 3+N, where N represents the total dimensionality of the response signals that are collected in each test location measurement.

In some examples, the method 500 includes, for at least one repeated sample test location, repeating the performing the test location measurement at 516 at a repeated phase delay in non-consecutive test location measurements. Such non-consecutive test location measurements may correspond to test location measurements performed while recording different respective data frames. For example, with reference to the first set 210 of phase-redundant data frames in FIG. 2, each sample test location 202 may be described as representing such a repeated sample test location, since each sample test location is tested with a repeated phase delay (in this case, Δ₁) in non-consecutive measurements corresponding to different data frames.

In some examples, the recording the data frame(s) at 510 includes, for each data frame, repeating the performing the test location measurement at 516 at each sample test location a plurality of times before performing the test location measurement at a sample test location. For example, and as described above, repeated test location measurements can be made at a given sample test location and for a given phase delay to accumulate data corresponding to multiple illumination pulses.

In this manner, the total illumination flux needed to obtain a signal with a sufficient SNR may be distributed among a plurality of consecutive test location measurements performed at a given sample test location with a given phase delay as well as a plurality of non-consecutive test location measurements performed at the given sample test location for different data frames. As discussed above, distributing at least a portion of the total illumination flux across different data frames can yield valuable information regarding the state of the experiment more quickly and/or can help preserve the integrity of the sample. In some examples, for each data frame, all pairs of consecutive test location measurements may be performed at different respective sample test locations.

In some examples, and as discussed above in the context of FIG. 2, the repeating the performing the test measurement at 516 can include performing the test location measurement at each sample test location a plurality of times with the repeated phase delay to yield an aggregated data set that correspond to the repeated sample test location and the repeated phase delay. In such examples, the method 500 may include contracting, at 534, the aggregated data set for each repeated sample test location and for each repeated phase delay.

The contracting the aggregated data set at 534 can include combining the data in the aggregated data set in any of a variety of manners, such as by summing and/or integrating the aggregated data set. As an example, with reference to the first set 210 of phase-redundant data frames of FIG. 2, an aggregated data set corresponding to each sample test location 202 can include all of the response signals regarded at the sample test location across all data frames of the first set 210. In such an example, the contracting the aggregated data set at 534 can include summing and/or integrating all of the individual response signals to yield a single contracted data point representing the response of the sample test location with the repeated phase delay.

In some examples, the repeating the performing the test location measurement at 516 includes recording a plurality of repeated data frames with similar and/or identical measurement parameters. For example, as shown in FIG. 5, the recording the data frame(s) at 510 can include recording, at 512, a plurality of phase-redundant data frames as described above. In particular, for each sample test location of the plurality of sample test locations, the test location measurement is performed with the same phase delay for each data frame in the plurality of phase-redundant data frames.

In some examples, the method 500 additionally includes repeating the recording the phase-redundant data frames at 512 at each of a plurality of different phase delays. The sequence shown in FIG. 2 represents an example of such a method, with each of the first set 210, the second set 220, and the third set 230 of phase-redundant data frames individually representing a result of a respective iteration of the recording at 512. In this example, the recording the phase-redundant data frames at 512 is repeated with different phase delays to produce the collection of different sets of phase-redundant data frames.

In some examples, and as shown in FIG. 5, the recording the data frame(s) at 510 includes recording, at 514, a plurality of phase-varying data frames as described above. In particular, for each data frame in the plurality of phase-varying data frames, the test location measurement is performed at each sample test location with a phase delay corresponding to the data frame that is different that the phase delay corresponding to each other data frame. As described above in the context of FIGS. 2-3, selected data frames taken from each of a plurality of different sets of phase-redundant data frames may be described as representing a set of phase-varying data frames.

In some examples, for at least one data frame, the method 500 includes performing the test location measurement with the same phase delay for each sample test location. For example, in the example of FIG. 2, each of the data frames 200a-200f is recorded such that, within each data frame, the same phase delay is used in every sample test location. In some such examples, the method 500 can include performing the test location measurement at each sample test location exactly once, such that consecutive test location measurements are performed at different sample test locations. In other examples, the method 500 can include performing a plurality of test location measurements at each sample test location with a given phase delay before progressing to a subsequent sample test location.

Additionally, or alternatively, the method 500 can include performing the test location measurement with different phase delays at each of two or more sample test locations in at least one data frame. For example, in the example of FIG. 3, each of the data frames 300a-300f includes different sample test locations at which different phase delays are used.

More specifically, and as discussed above in the context of FIG. 3, the sample test locations of a data frame may be partitioned into (at least) a first location subset and a second location subset in which different respective first and second phase delays are used. Accordingly, as shown in FIG. 5, the method 500 can include, for at least one data frame, performing, at 518, the test location measurements with a first phase delay at each sample test location of the first location subset. Similarly, the method 500 can include, for the same data frame(s), performing, at 520, the test location measurements with a second phase delay that is different from the first phase delay at each sample test location of the second location subset. In various examples, the method 500 similarly can include using a different third phase delay in a third location subset, using a different fourth phase delay in a fourth location subset, and so forth.

In some examples, the recording the data frame(s) at 510 includes, for at least one data frame, performing the test location measurement at each sample test location such that a single phase delay is used at each (individual) sample test location and such that different respective phase delays are used at each of two or more different sample test locations. The examples of FIGS. 3-4 also may be described as representing examples of such a method. In particular, the different sample test locations corresponding to different phase delays may be selected from the first location subset and the second location subset of the data frames of FIG. 3. Similarly, the different sample test locations corresponding to different phase delays may correspond to any two different sample test locations of any data frame of FIG. 4.

In some examples, the method 500 may include analyzing one or more of the recorded data frames to yield information regarding the state of an experiment being performed before all data frames are recorded. In such examples, such data frames that may be analyzed in an intermediate stage of the method may be referred to as one or more test data frames.

As shown in FIG. 5, the method 500 may include, subsequent to recording the test data frame(s), analyzing, at 528, the one or more test frames to yield intermediate information regarding the sample. In some examples, the analyzing the data frame(s) at 528 includes generating, at 530, an intermediate representation of the sample. The intermediate representation can be at least partially based on one or more of the test data frame(s). As discussed above in the context of FIG. 2, the intermediate representation can assume any of a variety of forms, such as a data file to be analyzed by a computer processor and/or a graphical representation to be displayed to a user.

In some examples, the intermediate information and/or the intermediate representation can be used to update one or more aspects of an experimental procedure. For example, and as shown in FIG. 5, the method 500 additionally can include adjusting, at 532, one or more measurement parameters of a charged particle microscope system (e.g., the CPM system 100 of FIG. 1) with which the method 500 is being performed. The adjusting the measurement parameter(s) at 532 may be performed at least partially based on the intermediate information and/or the intermediate representation. The adjusting the measurement parameter(s) at 532 can be performed subsequent to recording the test data frame(s) and prior to recording a subsequent data frame.

In some examples, the adjusting the measurement parameter(s) at 532 is performed at least partially automatically, such as by a controller of the charged particle microscope system (e.g., the controller 160). For example, an automated comparison of the intermediate representations corresponding to two different test data frames can indicate an extent to which the sample has drifted spatially, and the controller may automatically adjust the scan of the charged particle beam to counteract the effect of such drift.

Additionally, or alternatively, the adjusting the measurement parameter(s) at 532 may be performed at least partially manually and/or in response to a user input. For example, the method 500 may include displaying the intermediate information and/or the intermediate representation to a user, who may then choose to adjust one or more experimental parameters based on the intermediate information.

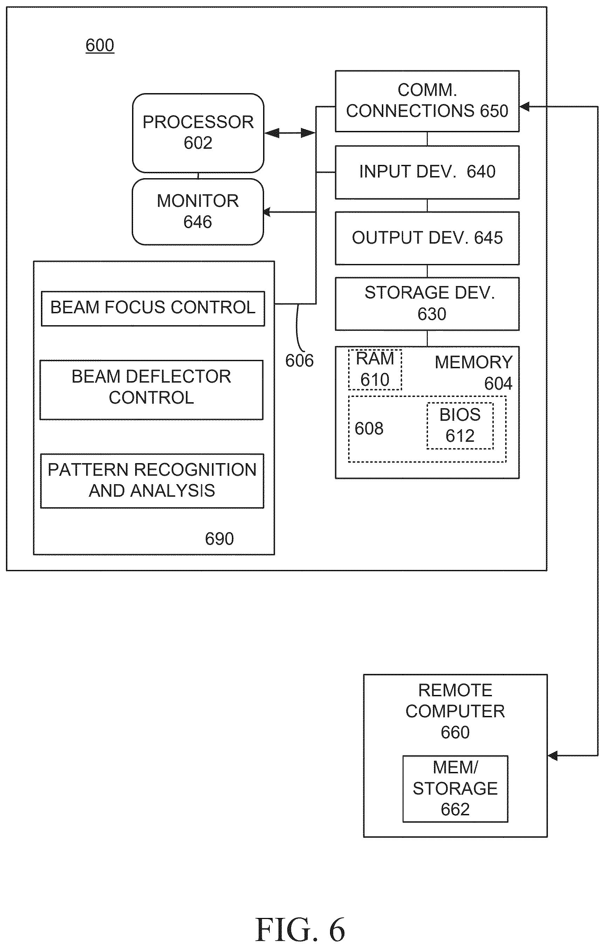

FIG. 6 and the following discussion are intended to provide a brief, general description of an exemplary computing environment in which the disclosed technology may be implemented. In particular, some or all portions of this computing environment can be used with the above methods and apparatus to, for example, direct a charged particle beam and/or an excitation stimulus to a sample test location, to perform a test location measurement, and/or perform any portions of the methods disclosed above.

Although not required, the disclosed technology is described in the general context of computer executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand-held devices, tablets, multiprocessor systems, microprocessor-based or programmable consumer electronics, network PCs, minicomputers, mainframe computers, virtual machines, containerized applications, Kubernetes clusters, and the like. The disclosed technology also may be practiced in distributed computing environments where tasks are performed by remote processing devices that are linked through a communications network. In a distributed computing environment, program modules may be located in both local and remote memory storage devices. In some cases, such processing is provided in a CPM system. The disclosed systems can serve to control image acquisition and provide a user interface as well as serve as an image processor.

With reference to FIG. 6, an exemplary system for implementing the disclosed technology includes a general-purpose computing device in the form of an exemplary conventional PC 600, including one or more processing units 602, a system memory 604, and a system bus 606 that couples various system components including the system memory 604 to the one or more processing units 602. Each processing unit 602 of the one or more processing units 602 additionally or alternatively may be referred to as a processor 602, and the one or more processing units 602 collectively may be referred to as a processor system. The system bus 606 may be any of several types of bus structures including a memory bus or memory controller, a peripheral bus, and a local bus using any of a variety of bus architectures. The exemplary system memory 604 includes read-only memory (ROM) 608 and random-access memory (RAM) 610. A basic input/output system (BIOS) 612, containing the basic routines that help with the transfer of information between elements within the PC 600, is stored in ROM 608. In various examples, the PC 600 (and/or one or more components thereof) additionally or alternatively may be referred to as a controller. The PC 600 may represent an example of at least a portion of the controller 160 of FIG. 1.

The exemplary PC 600 further includes one or more storage devices 630 such as a hard disk drive for reading from and writing to a hard disk, a magnetic disk drive for reading from or writing to a removable magnetic disk, and an optical disk drive for reading from or writing to a removable optical disk (such as a CD-ROM or other optical media). Such storage devices can be connected to the system bus 606 by a hard disk drive interface, a magnetic disk drive interface, and an optical drive interface, respectively. The drives and their associated computer readable media provide nonvolatile storage of computer-readable instructions, data structures, program modules, and other data for the PC 600. Other types of computer-readable media which can store data that is accessible by a PC, such as magnetic cassettes, flash memory cards, solid-state drives, digital video disks, CDs, DVDs, RAMs, ROMs, and the like, may also be used in the exemplary operating environment.

A number of program modules may be stored in the storage devices 630 including an operating system, multiple operating systems, virtual operating systems, one or more application programs, other program modules, and/or program data. In some examples, one or more aspects of the methods disclosed herein may be programmed, implemented, encoded, trained, and/or otherwise transferred to the program modules via machine learning, neural networks, artificial intelligence, etc.

The exemplary PC 600 can include various devices configured for user interface. For example, a user may enter commands and information into the PC 600 through one or more input devices 640 such as a keyboard and/or a pointing device such as a mouse. For example, the user may enter commands to initiate image acquisition and/or to initiate one or more methods disclosed herein. Other input devices may include a digital camera, microphone, joystick, game pad, buttons, dials, satellite dish, scanner, or the like. In some examples, several such input devices can be integrated into a single user interface device, such as may be commonly used in conjunction with a CPM system. These and other input devices are often connected to the one or more processing units 602 through a serial port interface that is coupled to the system bus 606, but may be connected by other interfaces such as a parallel port, game port, universal serial bus (USB), or wired or wireless network connection. A monitor 646 or other type of display device is also connected to the system bus 606 via an interface, such as a video adapter, and can display, for example, one or more images of a sample or specimen prior to, subsequent to, and/or during performance of one or more methods disclosed herein. The monitor 646 can also be used to select sections for processing or particular image alignment and alignment procedures such as correlation, feature identification, and preview area selection or other image selection. Other peripheral output devices, such as speakers and printers (not shown), may be included. The input device 640 may represent an example of the user input device 166 of FIG. 1. Additionally, or alternatively, the monitor 646 may represent an example of the display device 168 of FIG. 1.

The PC 600 may operate in a networked environment using logical connections to one or more remote computers, such as a remote computer 660. In some examples, one or more network or communication connections 650 are included. The remote computer 660 may be another PC, a server, a router, a network PC, and/or a peer device or other common network node, and typically includes many or all of the elements described above relative to the PC 600, although only a memory storage device 862 has been illustrated in FIG. 6. The personal computer 600 and/or the remote computer 660 can be connected to a local area network (LAN) and/or a wide area network (WAN). Such networking environments are commonplace in offices, enterprise wide computer networks, intranets, and the Internet.

As shown in FIG. 6, a memory 690 (or portions of this or other memory) can store processor-executable instructions for beam focus control, beam deflector control, pattern recognition and analysis (e.g., to detect and/or characterize a drift of a sample relative to a charged particle beam), etc. Such processor-executable instructions additionally or alternatively can include instructions for performing various calculations and/or for executing various measurement routines, such as those described herein. For example, such processor-executable instructions can, when executed by a processor system, cause the PC 600 and/or another component (e.g., any suitable components of the CPM system 100 of FIG. 1) to execute any of the methods disclosed herein. In some examples, processor-executable instructions can produce displayed images (e.g., of an intermediate representation of the sample), processing of preview images, and/or acquisition of additional images.

### General Considerations

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

Unless otherwise stated, as used herein, the term "substantially" means the listed value and/or property and any value and/or property that is at least 75% of the listed value and/or property. Equivalently, the term "substantially" means the listed value and/or property and any value and/or property that differs from the listed value and/or property by at most 25%. For example, "substantially equal" refers to quantities that are fully equal, as well as to quantities that differ from one another by up to 25%.

The systems, apparatus, and methods described herein should not be construed as limiting in any way. Instead, the present disclosure is directed toward all novel and non-obvious features and aspects of the various disclosed examples, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, and the like may be characterized by qualifying terms such as "lowest," "best," "minimum ," "extreme," etc. It is to be understood that such descriptions are intended to indicate that a selection among many used functional alternatives can be made, and such selections need not be better, smaller, or otherwise preferable to other selections.

The innovations can be described in the general context of computer-executable instructions, such as those included in program modules, being executed in a computing system on a target real or virtual processor. Generally, program modules or components include routines, programs, libraries, objects, classes, components, data structures, etc. that perform particular tasks or implement particular abstract data types. The functionality of the program modules may be combined or split between program modules as desired in various examples. Computer-executable instructions for program modules may be executed within a local or distributed computing system. In general, a computing system or computing device can be local or distributed, and can include any combination of special-purpose hardware and/or general-purpose hardware with software implementing the functionality described herein, examples of which include personal computers, hand-held devices, tablets, multiprocessor systems, microprocessor-based or programmable consumer electronics, network PCs, minicomputers, mainframe computers, virtual machines, containerized applications, etc.

In various examples described herein, a module (e.g., component or engine) can be "programmed" and/or "coded" to perform certain operations or provide certain functionality, indicating that computer-executable instructions for the module can be executed to perform such operations, cause such operations to be performed, or to otherwise provide such functionality. Although functionality described with respect to a software component, module, or engine can be carried out as a discrete software unit (e.g., program, function, class method), it need not be implemented as a discrete unit. That is, the functionality can be incorporated into a larger or more general-purpose program, such as one or more lines of code in a larger or general-purpose program.

Described algorithms may be, for example, embodied as software or firmware instructions carried out by a digital computer. For instance, any of the disclosed methods can be performed by one or more a computers or other computing hardware that is part of a microscopy tool. The computers can be computer systems comprising one or more processors (processing devices) and tangible, non-transitory computer-readable media (e.g., one or more optical media discs, volatile memory devices (such as DRAM or SRAM), or nonvolatile memory or storage devices (such as hard drives, NVRAM, and solid-state drives (e.g., Flash drives)). The one or more processors can execute computer-executable instructions stored on one or more of the tangible, non-transitory computer-readable media, and thereby perform any of the disclosed techniques. For instance, software for performing any of the disclosed examples can be stored on the one or more volatile, non-transitory computer-readable media as computer-executable instructions, which when executed by the one or more processors, cause the one or more processors to perform any of the disclosed techniques or subsets of techniques.

### Additional Examples of the Disclosed Technology

Having described and illustrated the principles of the disclosed technology with reference to the illustrated examples, it will be recognized that the illustrated examples can be modified in arrangement and detail without departing from such principles. For instance, elements of examples performed in software may be implemented in hardware and vice-versa. Also, the technologies from any example can be combined with the technologies described in any one or more of the other examples. It will be appreciated that procedures and functions such as those described with reference to the illustrated examples can be implemented in a single hardware or software module, or separate modules can be provided. The particular arrangements above are provided for convenient illustration, and other arrangements can be used.

Example 1. A method of collecting a data set, comprising: recording a plurality of data frames by, for each data frame of the plurality of data frames: performing a test location measurement at each sample test location of a plurality of sample test locations of a sample, wherein the performing the test location measurement comprises, for each sample test location: applying an excitation stimulus to the sample test location at a stimulus time; directing a charged particle beam to the sample test location at a probe time that is separated from the stimulus time by a phase delay; and recording one or more response signals that are generated via an interaction between the charged particle beam and the sample, wherein the method comprises, for at least one repeated sample test location, repeating the performing the test location measurement at a repeated phase delay in non-consecutive test location measurements.

Example 2. The method of any example herein, particularly example 1, wherein the data set has a dimensionality of 3+N, where N represents the dimensionality of the one or more response signals.

Example 3. The method of any example herein, particularly any one of examples 1-2, wherein the plurality of sample test locations forms a two-dimensional grid of locations on the sample.

Example 4. The method of any example herein, particularly any one of examples 1-3, further comprising: scanning the charged particle beam relative to the sample to direct the charged particle beam to each sample test location; and synchronizing the scanning the charged particle beam with the performing the test location measurement.

Example 5. The method of any example herein, particularly example 4, wherein the directing the charged particle beam to the sample test location comprises directing an illumination pulse to the sample test location, and wherein the synchronizing comprises directing the same number of illumination pulses to each sample test location.

Example 6. The method of any example herein, particularly any one of examples 1-5, wherein the recording the plurality of data frames comprises, for each data frame of the plurality of data frames, repeating the performing the test location measurement at each sample test location a plurality of times before performing the test location measurement at a subsequent sample test location.

Example 7. The method of any example herein, particularly any one of examples 1-6, wherein, for each data frame of the plurality of data frames, consecutive test location measurements are performed at different sample test locations.

Example 8. The method of any example herein, particularly any one of examples 1-7, wherein the repeating the performing the test location measurement comprises performing the test location measurement at each repeated sample test location a plurality of times with the repeated phase delay to yield an aggregated data set corresponding to the repeated sample test location and to the repeated phase delay, and wherein the method further comprises, for each repeated sample test location and for each repeated phase delay, contracting the aggregated data set.

Example 9. The method of any example herein, particularly example 8, wherein the contracting the aggregated data set comprises integrating the aggregated data set.

Example 10. The method of any example herein, particularly any one of examples 1-9, wherein the repeating the performing the test location measurement comprises recording a plurality of repeated data frames with identical measurement parameters.

Example 11. The method of any example herein, particularly any one of examples 1-10, wherein the recording the plurality of data frames comprises recording a plurality of phase-redundant data frames such that, for each sample test location of the plurality of sample test locations, the test location measurement is performed with the same phase delay for each data frame in the plurality of phase-redundant data frames.

Example 12. The method of any example herein, particularly example 11, further comprising repeating the recording the plurality of phase-redundant data frames at each a plurality of different phase delays.

Example 13. The method of any example herein, particularly any one of examples 1-12, wherein the recording the plurality of data frames comprises recording a plurality of phase-varying data frames such that, for each data frame in the plurality of phase-varying data frames, the test location measurement is performed at each sample test location with a phase delay corresponding to the data frame that is different that the phase delay corresponding to each other data frame.

Example 14. The method of any example herein, particularly any one of examples 1-13, wherein, for at least one data frame of the plurality of data frames, the method comprises performing the test location measurement with the same phase delay for each sample test location of the plurality of sample test locations.

Example 15. The method of any example herein, particularly example 14, wherein, for the at least one data frame of the plurality of data frames, the method comprises performing the test location measurement at each sample test location exactly once.

Example 16. The method of any example herein, particularly any one of examples 1-15, wherein, for at least one data frame of the plurality of data frames, the method comprises performing the test location measurement with different phase delays at each of two or more sample test locations of the plurality of sample test locations.

Example 17. The method of any example herein, particularly any one of examples 1-16, wherein, for at least one data frame of the plurality of data frames, the method comprises: performing the test location measurements with a first phase delay at each sample test location of a first location subset of the plurality of sample test locations; and performing the test location measurements with a second phase delay, which is different from the first phase delay, at each sample test location of a second location subset of the plurality of sample test locations.

Example 18. The method of any example herein, particularly example 17, wherein the first location subset and the second location subset are non-overlapping subsets of the plurality of sample test locations.

Example 19. The method of any example herein, particularly any one of examples 17-18, wherein the first location subset and the second location subset correspond to interlaced portions of the plurality of sample test locations.

Example 20. The method of any example herein, particularly any one of examples 1-19, wherein the applying the excitation stimulus to the sample test location comprises applying the excitation stimulus to a region of the sample that encompasses multiple sample test locations.

Example 21. The method of any example herein, particularly any one of examples 1-20, wherein the applying the excitation stimulus to the sample test location comprises directing a laser pulse to the sample.

Example 22. The method of any example herein, particularly example 21, wherein, for each test location measurement, the laser pulse is incident upon the sample for a duration that is less than 1 picosecond (ps).

Example 23. The method of any example herein, particularly any one of examples 1-22, wherein the directing the charged particle beam to the sample test location comprises directing a charged particle beam pulse to the sample test location.

Example 24. The method of any example herein, particularly example 23, wherein the charged particle beam pulse is incident upon the sample for a duration that is less than 1 ps.

Example 25. The method of any example herein, particularly any one of examples 1-24, wherein the directing the charged particle beam to the sample test location comprises directing the charged particle beam with one or more scan coils of a charged particle microscope system.

Example 26. The method of any example herein, particularly any one of examples 1-25, wherein the recording the one or more response signals comprises one or more of: (i) recording a bright-field signal; (ii) recording an annular bright-field signal; (iii) recording an annular dark-field signal; (iv) recording a high-angle annular dark-field signal; (v) recording an energy-dispersive X-ray spectroscopy signal; (vi) recording an electron energy loss spectroscopy signal; (vii) recording a differential phase contrast signal; (viii) recording a convergent beam electron diffraction signal; (ix) recording a backscattered electron signal; or (x) recording a secondary electron signal.

Example 27. The method of any example herein, particularly any one of examples 1-26, wherein the recording the one or more response signals comprises recording with a pixelated electron detector.

Example 28. The method of any example herein, particularly any one of examples 1-27, wherein the recording the one or more response signals comprises recording signals corresponding to two or more different analytical methodologies.

Example 29. The method of any example herein, particularly any one of examples 1-28, wherein the recording the one or more response signals comprises recording with two or more separate detector devices.

Example 30. The method of any example herein, particularly any one of examples 1-29, further comprising, subsequent to recording one or more test data frames of the plurality of data frames and prior to recording a subsequent data frame of the plurality of data frames, analyzing the one or more test data frames to yield intermediate information regarding the sample.

Example 31. The method of any example herein, particularly example 30, wherein the analyzing the one or more test data frames comprises generating an intermediate representation of the sample based, at least in part, on the one or more test data frames.

Example 32. The method of any example herein, particularly any one of examples 30-31, wherein the method is performed, at least in part, by a charged particle microscope system, and wherein the method further comprises, subsequent to recording the one or more test data frames and prior to recording the subsequent data frame, adjusting one or more measurement parameters of the charged particle microscope system based, at least in part, on the intermediate information.

Example 33. The method of any example herein, particularly example 32, wherein the adjusting is performed at least partially automatically.

Example 34. The method of any example herein, particularly any one of examples 32-33, further comprising displaying the intermediate information to a user, and wherein the adjusting is performed at least partially in response to a user input.

Example 35. A method of collecting a data set, comprising: recording a data frame by: performing a test location measurement at each sample test location of a plurality of sample test locations of a sample, wherein the performing the test location measurement comprises, for each sample test location: applying an excitation stimulus to the sample test location at a stimulus time; directing a charged particle beam to the sample test location at a probe time that is separated from the stimulus time by a phase delay; and recording one or more response signals that are generated via an interaction between the charged particle beam and the sample, wherein the recording the data frame comprises: performing the test location measurement at each sample test location such that a single phase delay is used at each sample test location; and performing the test location measurement with different respective phase delays at each of two or more different sample test locations of the plurality of sample test locations.

Example 36. The method of any example herein, particularly example 35, further comprising: scanning the charged particle beam relative to the sample to direct the charged particle beam to each sample test location; and synchronizing the scanning the charged particle beam with the performing the test location measurement.

Example 37. The method of any example herein, particularly example 36, wherein the directing the charged particle beam to the sample test location comprises directing an illumination pulse to the sample test location, and wherein the synchronizing comprises directing the same number of illumination pulses to each sample test location.

Example 38. The method of any example herein, particularly any one of examples 35-37, further comprising repeating the recording the data frame to yield a plurality of data frames.

Example 39. The method of any example herein, particularly example 38, wherein, for each data frame of the plurality of data frames, each sample test location is associated with each phase delay according to a phase mapping, and wherein each frame of the plurality of data frames is characterized by the same phase mapping.

Example 40. The method of any example herein, particularly any one of examples 35-39, wherein consecutive test location measurements are performed at different sample test locations.

Example 41. The method of any example herein, particularly any one of examples 35-40, further comprising: performing the test location measurements with a first phase delay at each sample test location of a first location subset of the plurality of sample test locations; and performing the test location measurements with a second phase delay, which is different from the first phase delay, at each sample test location of a second location subset of the plurality of sample test locations. Example 42. The method of any example herein, particularly example 41, wherein the first location subset and the second location subset are non-overlapping subsets of the plurality of sample test locations.

Example 43. The method of any example herein, particularly any one of examples 41-42, wherein the first location subset and the second location subset correspond to interlaced portions of the plurality of sample test locations.

Example 44. The method of any example herein, particularly any one of examples 35-43, wherein the applying the excitation stimulus to the sample test location comprises applying the excitation stimulus to a region of the sample that encompasses multiple sample test locations.

Example 45. The method of any example herein, particularly any one of examples 35-44, wherein the applying the excitation stimulus to the sample test location comprises directing a laser pulse to the sample.

Example 46. The method of any example herein, particularly example 45, wherein, for each test location measurement, the laser pulse is incident upon the sample for a duration that is less than 1 ps.

Example 47. The method of any example herein, particularly any one of examples 35-46, wherein the directing the charged particle beam to the sample test location comprises directing a charged particle beam pulse to the sample test location.

Example 48. The method of any example herein, particularly example 47, wherein the charged particle beam pulse is incident upon the sample for a duration that is less than 1 ps.

Example 49. The method of any example herein, particularly any one of examples 35-48, wherein the directing the charged particle beam to the sample test location comprises directing the charged particle beam with one or more scan coils of a charged particle microscope system.

Example 50. The method of any example herein, particularly any one of examples 35-49, wherein the recording the one or more response signals comprises one or more of: (i) recording a bright-field signal; (ii) recording an annular bright-field signal; (iii) recording an annular dark-field signal; (iv) recording a high-angle annular dark-field signal; (v) recording an energy-dispersive X-ray spectroscopy signal; (vi) recording an electron energy loss spectroscopy signal; (vii) recording a differential phase contrast signal; (viii) recording a convergent beam electron diffraction signal; (ix) recording a backscattered electron signal; or (x) recording a secondary electron signal.

Example 51. The method of any example herein, particularly any one of examples 35-50, wherein the recording the one or more response signals comprises recording with a pixelated electron detector.

Example 52. The method of any example herein, particularly any one of examples 35-51, wherein the recording the one or more response signals comprises recording signals corresponding to two or more different analytical methodologies.

Example 53. The method of any example herein, particularly any one of examples 35-52, wherein the recording the one or more response signals comprises recording with two or more separate detector devices.

Example 54. The method of any example herein, particularly any one of examples 35-53, wherein the data frame is a test data frame, and wherein the method further comprises, subsequent to recording the test data frame and prior to recording a subsequent data frame, analyzing the test data frame to yield intermediate information regarding the sample.

Example 55. The method of any example herein, particularly example 54, wherein the analyzing the test data frame comprises generating an intermediate representation of the sample based, at least in part, on the test data frame.

Example 56. The method of any example herein, particularly any one of examples 54-55, wherein the method is performed, at least in part, by a charged particle microscope system, and wherein the method further comprises, subsequent to recording the test data frame and prior to recording the subsequent data frame, adjusting one or more measurement parameters of the charged particle microscope system based, at least in part, on the intermediate information.

Example 57. The method of any example herein, particularly example 56, wherein the adjusting is performed at least partially automatically.

Example 58. The method of any example herein, particularly any one of examples 56-57, further comprising displaying the intermediate information to a user, and wherein the adjusting is performed at least partially in response to a user input.

Example 59. A charged particle microscope (CPM) system comprising: a charged particle emitter configured to generate a charged particle beam; an optical assembly configured to direct and focus an illumination pulse of the charged particle beam to a sample test location on a sample positioned in a sample plane; an excitation source configured to apply an excitation stimulus to the sample test location; a detector subassembly configured to receive one or more response signals that are generated via an interaction between the illumination pulse and the sample; and a controller comprising a processor system and a memory comprising instructions that, when executed by the processor system, cause the CPM system to perform the method of any example herein, particularly any one of examples 1-58.

Example 60. The CPM system of any example herein, particularly example 59, wherein two or more of: (i) the CPM system comprises a bright-field electron detector, and the recording the one or more response signals comprises recording a bright-field signal with the bright-field electron detector; (ii) the CPM system comprises an annular bright-field electron detector, and the recording the one or more response signals comprises recording an annular bright-field signal with the annular bright-field electron detector; (iii) the CPM system comprises an annular dark-field electron detector, and the recording the one or more response signals comprises recording an annular dark-field signal with the annular dark-field electron detector; (iv) the CPM system comprises a high-angle annular dark-field electron detector, and the recording the one or more response signals comprises recording a high-angle annular dark-field signal with the high-angle annular dark-field electron detector; (v) the CPM system comprises an X-ray detector, and the recording the one or more response signals comprises recording an energy-dispersive X-ray spectroscopy signal with the X-ray detector; (vi) the CPM system comprises an electron energy loss spectroscopy module, and the recording the one or more response signals comprises recording an electron energy loss spectroscopy signal with the electron energy loss spectroscopy module; (vii) the CPM system comprises a segmented electron detector, and the recording the one or more response signals comprises recording a differential phase contrast signal with the segmented electron detector; (viii) the CPM system comprises a pixelated electron detector, and the recording the one or more response signals comprises recording a convergent beam electron diffraction signal with the pixelated electron detector; (ix) the CPM system comprises a backscattered electron detector, and the recording the one or more response signals comprises recording a backscattered electron signal with the backscattered electron detector; or (x) the CPM system comprises a secondary electron detector, and the recording the one or more response signals comprises recording a secondary electron signal with the secondary electron detector.

Example 61. The CPM system of any example herein, particularly any one of examples 59-60, wherein the excitation source comprises a laser source, and wherein the applying the excitation stimulus comprises directing a laser pulse to the sample such that the laser pulse is incident upon the sample for a duration that is less than 1 ps.

Example 62. The CPM system of any example herein, particularly any one of examples 59-61, wherein the CPM system comprises a scanning electron microscope (SEM) system, wherein the charged particle emitter comprises an electron emitter, and wherein the charged particle beam comprises an electron beam.

Example 63. The CPM system of any example herein, particularly any one of examples 59-62, wherein the CPM system comprises a scanning transmission electron microscope (STEM) system, wherein the charged particle emitter comprises an electron emitter, and wherein the charged particle beam comprises an electron beam.

In view of the many possible embodiments to which the principles of the disclosed invention may be applied, it should be recognized that the illustrated embodiments are only preferred examples of the invention and should not be taken as limiting the scope of the invention. Rather, the scope of the invention is defined by the following claims. We therefore claim as our invention all that comes within the scope and spirit of these claims.

## Claims

1. A method of collecting a data set, comprising:
recording a plurality of data frames by, for each data frame of the plurality of data frames:
performing a test location measurement at each sample test location of a plurality of sample test locations of a sample, wherein the performing the test location measurement comprises, for each sample test location:
applying an excitation stimulus to the sample test location at a stimulus time;
directing a charged particle beam to the sample test location at a probe time that is separated from the stimulus time by a phase delay; and
recording one or more response signals that are generated via an interaction between the charged particle beam and the sample,
wherein the method comprises, for at least one repeated sample test location, repeating the performing the test location measurement with a repeated phase delay in non-consecutive test location measurements.

2. The method of claim 1, wherein the repeating the performing the test location measurement comprises performing the test location measurement at each repeated sample test location a plurality of times with the repeated phase delay to yield an aggregated data set corresponding to the repeated sample test location and to the repeated phase delay, and wherein the method further comprises, for each repeated sample test location and for each repeated phase delay, integrating the aggregated data set.

3. The method of either claim 1 or claim 2, wherein the recording the plurality of data frames comprises recording a plurality of phase-redundant data frames such that, for each sample test location of the plurality of sample test locations, the test location measurement is performed with the same phase delay for each data frame in the plurality of phase-redundant data frames.

4. The method of either claim 1 or claim 2, wherein the recording the plurality of data frames comprises recording a plurality of phase-varying data frames such that, for each data frame in the plurality of phase-varying data frames, the test location measurement is performed at each sample test location with a phase delay corresponding to the data frame that is different that the phase delay corresponding to each other data frame.

5. The method of any preceding claim, wherein, for at least one data frame of the plurality of data frames, the method comprises:
performing the test location measurement with the same phase delay for each sample test location of the plurality of sample test locations; and
performing the test location measurement at each sample test location exactly once.

6. The method of any preceding claim, wherein the recording the one or more response signals comprises recording with two or more separate detector devices.

7. The method of any preceding claim, further comprising, subsequent to recording one or more test data frames of the plurality of data frames and prior to recording a subsequent data frame of the plurality of data frames, analyzing the one or more test data frames to yield intermediate information regarding the sample.

8. The method of claim 7, wherein the method is performed, at least in part, by a charged particle microscope system, and wherein the method further comprises, subsequent to the recording the one or more test data frames and prior to the recording the subsequent data frame, adjusting one or more measurement parameters of the charged particle microscope system based, at least in part, on the intermediate information.

9. The method of claim 8, wherein the adjusting is performed at least partially automatically.

10. The method of claim 8, further comprising displaying the intermediate information to a user, and wherein the adjusting is performed at least partially in response to a user input.

11. A charged particle microscope (CPM) system comprising:
a charged particle emitter configured to generate a charged particle beam;
an optical assembly configured to direct and focus an illumination pulse of the charged particle beam to a sample test location on a sample positioned in a sample plane;
an excitation source configured to apply an excitation stimulus to the sample test location;
a detector subassembly configured to receive one or more response signals that are generated via an interaction between the illumination pulse and the sample; and
a controller comprising a processor system and a memory comprising instructions that, when executed by the processor system, cause the CPM system to record a plurality of data frames by, for each data frame of the plurality of data frames:
performing a test location measurement at each sample test location of a plurality of sample test locations of the sample, wherein the performing the test location measurement comprises:
applying the excitation stimulus to the sample test location with the excitation source at a stimulus time;
directing the illumination pulse to the sample test location at a probe time that is separated from the stimulus time by a phase delay; and
recording one or more response signals that are generated via an interaction between the charged particle beam and the sample,
wherein the memory comprises instructions that, when executed by the processor system, cause the processor system to repeat the performing the test location measurement with a repeated phase delay in non-consecutive test location measurements for at least one repeated sample test location.

12. The CPM system of claim 11, wherein two or more of:
(i) the CPM system comprises a bright-field electron detector, and the recording the one or more response signals comprises recording a bright-field signal with the bright-field electron detector;
(ii) the CPM system comprises an annular bright-field electron detector, and the recording the one or more response signals comprises recording an annular bright-field signal with the annular bright-field electron detector;
(iii) the CPM system comprises an annular dark-field electron detector, and the recording the one or more response signals comprises recording an annular dark-field signal with the annular dark-field electron detector;
(iv) the CPM system comprises a high-angle annular dark-field electron detector, and the recording the one or more response signals comprises recording a high-angle annular dark-field signal with the high-angle annular dark-field electron detector;
(v) the CPM system comprises an X-ray detector, and the recording the one or more response signals comprises recording an energy-dispersive X-ray spectroscopy signal with the X-ray detector;
(vi) the CPM system comprises an electron energy loss spectroscopy module, and the recording the one or more response signals comprises recording an electron energy loss spectroscopy signal with the electron energy loss spectroscopy module;
(vii) the CPM system comprises a segmented electron detector, and the recording the one or more response signals comprises recording a differential phase contrast signal with the segmented electron detector;
(viii) the CPM system comprises a pixelated electron detector, and the recording the one or more response signals comprises recording a convergent beam electron diffraction signal with the pixelated electron detector;
(ix) the CPM system comprises a backscattered electron detector, and the recording the one or more response signals comprises recording a backscattered electron signal with the backscattered electron detector; or
(x) the CPM system comprises a secondary electron detector, and the recording the one or more response signals comprises recording a secondary electron signal with the secondary electron detector.

13. The CPM system of either claim 11 or 12, wherein the excitation source comprises a laser source, and wherein the applying the excitation stimulus comprises directing a laser pulse to the sample such that the laser pulse is incident upon the sample for a duration that is less than 1 picosecond (ps).

14. The CPM system of any one of claims 11-13, wherein the memory further comprises instructions that, when executed by the processor system, cause the CPM system to, subsequent to recording a test data frame of the plurality of data frames and prior to recording a subsequent data frame of the plurality of data frames:
analyze the test data frame to yield intermediate information regarding the sample; and
automatically adjust one or more measurement parameters of the CPM system based, at least in part, on the intermediate information.
